# EUROPÄISCHE PATENTSCHRIFT

(11) **EP 1 231 824 B1**
(45) Veröffentlichungstag und Bekanntmachung des Hinweises auf die Patenterteilung: **20.04.2011**
(21) Anmeldenummer: 02450015.9
(22) Anmeldetag: 29.01.2002
(51) Int. Cl.: H05K 3/00, H05K 3/28

(54) **Verfahren zum Einbetten zumindest einer flexiblen Leiterbahnfolie in Kunststoff, Leiterbahneneinheit sowie Einbettungseinheit hierfür**
Process for embedding at least one conductive flexible printed circuit in plastic, conductive printed circuit device and embedding device
Procédé pour enrober un circuit imprimé flexible conducteur sur des matières plastiques, dispositif conducteur d'un circuit imprimé et dispositif d'intégration

(30) Priorität: 09.02.2001 AT 2012001
(43) Veröffentlichungstag der Anmeldung: 14.08.2002
(73) Patentinhaber: Pollmann Austria OHG, 3822 Karlstein/Thaya (AT)
(72) Erfinder: Lechner, Johannes, 3932 Kirchberg/Walde (AT)
(74) Vertreter: Weinzinger, Arnulf

(56) Entgegenhaltungen:
- EP-A- 0 511 014
- EP-A- 0 641 154
- EP-A- 0 708 583
- EP-A- 0 784 418
- DE-A- 4 407 508
- DE-C- 19 907 295
- US-A- 4 821 413
- US-A- 5 173 840
- US-A- 6 128 195

## Beschreibung

Die Erfindung betrifft ein Verfahren zum Einbetten zumindest einer flexiblen Leiterbahnfolie in Kunststoff.

In entsprechender Weise bezieht sich die Erfindung auf.eine elektrische Leiterbahneneinheit mit zumindest einer in Kunststoff eingebetteten Leiterbahnfolie, gegebenenfalls auch mit wenigstens einem im Kunststoff eingebetteten, z.B. elektrischen oder elektromechanischen Bauteil.

Weiters betrifft die Erfindung eine Einbettungseinheit zur Verwendung im erfindungsgemäßen Verfahren.

Aus der EP 784 418 A ist es bekannt, dreidimensionale Leiterformkörper durch Spritzgießen zu fertigen, wobei von einer Leiterplatte ausgegangen wird, die mit elektrischen Bauteilen, z.B. SMD-Komponenten, bestückt wird, und die vor dem Umspritzen mit Kunststoff an einer Biegestelle umgeformt wird, um an dieser Stelle Leuchtdioden zur Außenseite des Leiterformkörpers hin zu platzieren. Die Leiterplatte ist dabei im Wesentlichen steif, wodurch das Biege-Umformen sowie das Anspritzen oder Umspritzen mittels Kunststoff unproblematisch ist. Im Zuge der Miniaturisierung von Bauteilen ist es jedoch immer mehr gewünscht, anstatt relativ dicker Leiterplatten mit darauf angebrachten Leiterbahnen dünne, flexible Leiterbahnfolien zu verwenden, welche überdies den Vorteil bieten, dass sich die verschiedensten Leiterbahnkonfigurationen in Massenfertigung auf engstem Raum auf solchen Leiterbahnfolien realisieren lassen. Ein Beispiel für die Verwendung derartiger Leiterbahnfolien ist in der DE 197 32 223 A geoffenbart, wobei dort Isoliermaterial zwischen den Leiterbahnen angebracht wird und die Leiterbahnfolie insgesamt in einem Funktionsintegrationsmodul angeordnet wird.

In der EP 708 583 A1 sind ein elektrisches Gerät bzw. ein Verfahren zu dessen Herstellung beschrieben, wobei Leiterplattenteile, die über eine flexible Leiterbahn miteinander verbunden sind, an Gehäuseteilen angebracht werden, wonach sie mit einer zunächst flüssigen Schaumstoffmasse umgeben werden, die danach aushärtet, um zwischen den genannten Elementen eine mechanisch haltbare Verbindung zu schaffen.

Wünschenswert wäre es nun, Leiterbahnfolien ähnlich wie andere Leiterstrukturen zwecks Erzielung einer hermetischen Abdichtung, insbesondere für Anwendungen in Kraftfahrzeugtüren und dergl., mit Kunststoff umspritzen zu können. Dies ist jedoch wegen der Biegsamkeit der Leiterbahnfolien nicht ohne weiteres nicht ohne weiteres möglich, da sich die - instabile - Leiterbahnfolie im Spritzgusswerkzeug, wo sie in Distanz von den Werkzeugflächen zu halten ist, in den freien Bereichen beim Einbringen des heißen Kunststoffmaterials unter Druck ausbiegen würde, wobei es zum Wandern der Leiterbahnfolie, aber auch zum Reißen der Leiterbahnfolie kommt. Es wurde daher bereits versucht, ein Umspritzen von Leitexbahnfolien derart zu bewerkstelligen, dass die Leiterbahnfolie in einem ersten Schritt an einer Fläche des Spritzgusswerkzeuges zur Anlage gebracht und Kunststoffmaterial auf der gegenüberliegenden Seite der Leiterbahnfolie angespritzt wird, und dass nach Aushärten dieses Kunststoffmaterials das erhaltene Produkt bestehend aus Leiterbahnfolie mit einseitig angespritztem Kunststoff in einem anderen Spritzgusswerkzeug mit der Kunststoffseite an einer Werkzeugfläche zur Anlage gebracht wird, wonach ein Anspritzen von Kunststoff an der zweiten Seite der Leiterbahnfolie durchgeführt wird. Diese Vorgangsweise ist jedoch umständlich und aufwendig, da verschiedene Spritzgusswerkzeuge zum Fertigspritzen benötigt werden, wobei zwischen den beiden Anspritzschritten auch ein Abkühlschritt vorgesehen werden muss, um das im ersten Schritt angespritzte Kunststoffmaterial ausreichend starr werden zu lassen, und sie ist auch deshalb nachteilig, weil die Leiterbahnfolien, insbesondere mit daran angebrachten Bauteilen, zweimal der Beanspruchung durch Druck und Temperatur beim Anspritzen des Kunststoffmaterials ausgesetzt werden.

Aufgabe der Erfindung ist es nun, das Einbetten von Leiterbahnfolien im Kunststoffmaterial auf möglichst einfache Weise realisieren zu können, ohne dass die Leiterbahnfolie dabei der Gefahr einer Beschädigung ausgesetzt wird. Insbesondere soll es hierbei auch möglich sein, Leiterbahnfolien aus weniger festem und temperaturbeständigem Material als bisher erforderlich einsetzen zu können; nichtsdestoweniger sollen erfindungsgemäß hermetisch abgeschlossene, kompakte, vergleichsweise dünne Leiterbahneneinheiten erzielt werden können.

Zur Lösung dieser Aufgabe sieht die Erfindung ein Verfahren und eine elektrische Leiterbahneneinheit wie in den unabhängigen Ansprüchen definiert vor. Vorteilhafte Ausführungsformen und Weiterbildungen sind in den Unteransprüchen angegeben.

Gemäß der vorliegenden Erfindung wird ein vorgefertigtes Versteifungselement, insbesondere in Form eines Gehäuses, eingesetzt, um die Leiterbahnfolie beim Umspritzen (bzw. Eingießen oder Umgießen) mit Kunststoff gegen ein Verschwimmen und Verbiegen im Spritzgusswerkzeug zu sichern. An sich wäre es denkbar, dieses Versteifungselement im Wesentlichen plattenförmig auszubilden, wobei das Versteifungselement dann einseitig mit der Leiterbahnfolie, beispielsweise durch Ankleben an einzelnen Punkten, verbunden werden kann. Wenn jedoch die Leiterbahnfolie zwischen zwei Gehäuseteilen eingelegt wird, so ist sie von beiden Seiten her von vornherein gegen die relativ hohen Drücke und Temperaturen im Spritzgusswerkzeug beim Umspritzen des Kunststoffmaterials geschützt, wobei nichtsdestoweniger ebenfalls vergleichsweise außerordentlich dünne Baueinheiten, beispielsweise mit einer Dicke von ca. 4 mm oder weniger, erzielt werden können. Durch diesen Schutz der Leiterbahnfolie gegenüber Druck und Temperatur des Kunststoffmaterials ist es auch möglich, vergleichsweise preiswerte, weniger temperatur- und druckfeste Folienmaterialien zu verwenden. Das Versteifungselement bzw. Gehäuse kann in entsprechenden Stückzahlen einfach vorgefertigt und gelagert werden, so dass es bei Bedarf sofort verfügbar ist, wodurch der eigentliche Einbettungsvorgang, d.h. das Umspritzen der Leiterbahnfolie mit dem Kunststoffmaterial, rasch, ohne Verzögerung, durchgeführt werden kann. Das Versteifungselement bzw. Gehäuse kann im Spritzwerkzeug in der gewünschten Position stabil gehalten werden, im Gegensatz zu einer bloßen Leiterbahnfolie, die für sich zu instabil wäre und im Spritzgusswerkzeug "verschwimmt".

An den flexiblen Leiterbahnfolien können vor dem Umspritzen mit dem Kunststoff bereits elektrische und/oder elektromechanische Bauteile, wie Sensoren, Mikroschalter, und dabei insbesondere SMD-Komponenten (SMD - Surface Mounted Device) angebracht werden, und um diese Bauteile beim Umspritzungsvorgang zu schützen, kann das Versteifungselement bzw. Gehäuse mit einer beispielsweise haubenförmigen Aufnahme ausgebildet werden. Weiters kann das Versteifungselement, insbesondere das Gehäuse, mit außenseitigen Distanzelementen vorgefertigt werden, um das Versteifungselement samt Leiterbahnfolie im Spritzgusswerkzeug in Abstand von den Werkzeugflächen zu halten. Dadurch ist es möglich, das Spritzgusswerkzeug selbst einfach auszuführen. Andererseits ist es aber auch in vielen Fällen günstig, wenn beim Umspritzen des Versteifungselements samt Leiterbahnfolie im Spritzgusswerkzeug Stützkerne verwendet werden, um das Versteifungselement in Abstand von den Formflächen des Spritzgusswerkzeuges zu halten.

Im Rahmen der Erfindung können auch Sandwichstrukturen hergestellt werden, wobei mehrere flexible Leiterbahnfolien mit den zugehörigen Versteifungselementen übereinander angeordnet und mit dem Kunststoffmaterial umspritzt werden. Auch hier wirkt sich der erfindungsgemäß erzielte Effekt aus, dass die Versteifungselemente die Leiterbahnfolien gegen ein Verschwimmen im Spritzgusswerkzeug sichern und stabilisieren, wobei eine Einbettung der Sandwichstruktur in einer dünnen Kunststoffhülle möglich ist.

Zum Einbetten der Leiterbahnfolien samt Versteifungselementen kann ein thermoplastischer Kunststoff, wie an sich üblich, verwendet werden, wie insbesondere Polybutylenterephthalat (PBT) oder Polypropylen (PP), wobei aber auch andere Thermoplaste, wie ABS, in Frage kommen. Ferner ist es denkbar, duroplastische Kunststoffmaterialien zu verwenden.

Für die Leiterbahnfolien kann hingegen preiswertes Polyestermaterial verwendet werden. Selbstverständlich sind aber auch z.B. Polyimidfolien einsetzbar.

Sofern Bauteile größerer Dimensionen oder mit Zugänglichkeit von außerhalb des erzeugten Moduls vorzusehen sind, wie etwa ein Mikroschalter mit einer mechanischen "Abfrage", kann es auch vorteilhaft sein, für diese Bauteile eine gesonderte Aufnahme vorzusehen, wobei bevorzugt beim Umspritzen ein Aufnahmeteil für einen solchen Bauteil am Versteifungselement mitgespritzt werden kann.

Weiters ist es auch zu Zwecken der Kontaktierung denkbar, die flexible Leiterbahnfolie vor dem Umspritzen mit Kunststoff bereichsweise umzubiegen und mit diesem umgebogenen Bereich an einem beispielsweise stegförmigen Vorsprung des Versteifungselements zu fixieren. Dabei ist es überdies günstig, wenn zur Sicherung des umgebogenen Bereichs der flexiblen Leiterbahnfolie am Vorsprung des Versteifungselements nach dem Umspritzen mit Kunststoff unter Freilassung dieses Bereichs ein Ringelement auf den umgebogenen Bereich unter Klemmung aufgeschoben wird.

Wie bereits erwähnt wird bevorzugt als stabilisierendes, gegen Verbiegen sicherndes Versteifungselement ein Gehäuse mit einem Innenraum für die Aufnahme der flexiblen Leiterbahnfolie vorgesehen; dabei kann das Gehäuse einteilig mit einem von einer Seite her zugänglichen schlitzförmigen Innenraum ausgebildet sein, was jedoch mitunter herstellungstechnisch Probleme bereitet und überdies der vorhergehenden Bestückung der Leiterbahnfolie mit Bauteilen entgegensteht. Bevorzugt wird daher das Gehäuse mehrteilig, insbesondere zweiteilig, vorgesehen, wobei der eine Gehäuseteil ein Wannenteil sein kann, in den die Leiterbahnfolie eingelegt wird, und der andere Gehäuseteil als Deckelteil ausgeführt wird, der danach auf den Wannenteil aufgebracht wird. Die beiden Gehäuseteile können dabei als separate Teile vorgefertigt werden, es ist jedoch auch denkbar, die beiden Gehäuseteile in einem Stück vorzusehen, wobei sie über ein Filmscharnier miteinander verbunden sind, so dass sie in die Schließstellung zusammengeklappt werden können.

Die Erfindung schafft somit nicht nur ein vorteilhaftes Verfahren zum Umspritzen einer Leiterbahnfolie in einem einzigen Schritt sowie eine elektrische Leiterbahneneinheit mit einer derartigen Leiterbahnfolie, sondern darüber hinaus als Einbettungseinheit zur Verwendung im erfindungsgemäßen Verfahren ein vorgefertigtes Gehäuse mit zwei zusammenpassenden Gehäuseteilen, zwischen denen der Aufnahmeraum der Leiterbahnfolie vorliegt. In zumindest einem Gehäuseteil kann zumindest ein Fenster für die Kontaktierung der Leiterbahnfolie freigelassen sein, und in Ausrichtung dazu kann bei der fertigen Leiterbahneneinheit auch ein Fenster im Einbettungsmaterial beim Spritzvorgang freigelassen werden. Durch diese zueinander fluchtenden Fenster können somit die entsprechenden Leiterbahnen oder Kontaktflächen der Leiterbahnfolie kontaktiert werden. Die Kontaktierung selbst ist herkömmlich und nicht Gegenstand der vorliegenden Erfindung.

Die zur Distanzierung des Versteifungselements, insbesondere Gehäuses, mit der Leiterbahnfolie von den Werkzeugflächen des Spritzgusswerkzeuges vorgesehenen Distanzelemente können beispielsweise noppenförmig sein, und sie können über die gesamte Fläche des Versteifungselementes bzw. Gehäuses verteilt angeordnet sein. Die Höhe der Distanzelemente ist zweckmäßigerweise gleich, und sie kann derart bemessen sein, dass nach dem Umspritzvorgang alle Distanzelemente bündig mit der Außenseite des Kunststoff-Einbettungsmaterials abschließen.

Es sei noch auf die DE 44 07 508 A1 verwiesen, wo ein Verfahren zum Einbetten von elektrischen Leiterbahnen in Kunststoffmaterial beschrieben ist; allerdings liegen hier Leiterbahnen in Form von Stanzgittern vor, die als solche eine stabile Einheit bilden, wobei auf diese Stanzgitter vorhergehend Formteile aufgesteckt werden, die das jeweilige Stanzgitter auch dann halten, wenn Verbindungsstege zwischen Leiterbahnen des Stanzgitters aufgetrennt werden, bevor das Umspritzen mit Kunststoff durchgeführt wird. Diese Formteile werden dabei klemmend am Stanzgitter fixiert. Eine derartige klemmende Fixierung wäre selbstverständlich bei Leiterbahnfolien nicht möglich, und überdies würden derartige nur einen Teil des Stanzgitters übergreifende Formteile im Falle von Leiterbahnfolien auch nicht die erforderliche Stabilisierung der gesamten Leiterbahnfolie sicherstellen können.

Die Erfindung wird nachfolgend anhand von in der Zeichnung dargestellten bevorzugten Ausführungsbeispielen, auf die sie jedoch nicht beschränkt sein soll, noch weiter erläutert. Es zeigen:
Fig. 1 eine schaubildliche Ansicht einer vereinfachten elektrischen Leiterbahneneinheit, bei der eine Leiterbahnfolie mit Kunststoff umspritzt ist;
Fig. 2 in einer auseinander gezogenen Darstellung die Leiterbahnfolie zwischen zwei Gehäuseteilen vor dem Umspritzvorgang bei der Herstellung einer solchen Leiterbahneneinheit gemäß Fig. 1;
Fig. 3 eine Draufsicht auf die Leiterbahneneinheit gemäß Fig. 1 nach dem Fertigspritzen;
Fig. 4 eine Schnittdarstellung durch diese Leiterbahneneinheit gemäß der Linie IV-IV in Fig. 3;
Fig. 5 in einer Darstellung ähnlich Fig. 1 eine andere Leiterbahneneinheit nach dem Umspritzen mit Kunststoff, wobei in einem gesonderten Aufnahmeteil ein Mikroschalter als elektromechanischer Bauteil angebracht ist;
Fig. 6 in einer auseinander gezogenen Darstellung die einzelnen Bestandteile, nämlich Gehäuseteile, Leiterbahnfolien, Mikroschalter und Aufnahmeteil hiefür, vor dem Umspritzen mit Kunststoff;
Fig. 7 eine Draufsicht auf die Leiterbahneneinheit gemäß Fig. 5;
Fig. 8 einen Längsschnitt durch diese Leiterbahneneinheit gemäß der Linie VIII-VIII in Fig. 7;
Fig. 9 noch eine andere Leiterbahneneinheit nach dem Umspritzvorgang in einer schaubildlichen Darstellung;
Fig. 10 die beiden Gehäuseteile und die Leiterbahnfolie dieser Leiterbahneneinheit in auseinander gezogener Darstellung vor dem Umspritzen, wobei auch der in Fig. 9 in einem eigenen Aufnahmeteil gezeigte Mikroschalter veranschaulicht ist;
Fig. 11 eine Draufsicht auf die Leiterbahneneinheit gemäß Fig. 9;
Fig. 12 einen Schnitt durch diese Leiterbahneneinheit gemäß der Linie XII-XII in Fig. 11;
Fig. 13 einen vergleichbaren Längsschnitt durch noch eine andere - sandwichartige - Leiterbahneneinheit; und
die Fig. 14 und 15 in einer Schnittansicht bzw. Draufsicht eine Leiterbahneneinheit wie gemäß Fig. 1 bis 4, wobei jedoch zur Fixierung im Spritzgusswerkzeug während des Umspritzvorganges Stützkerne verwendet werden.

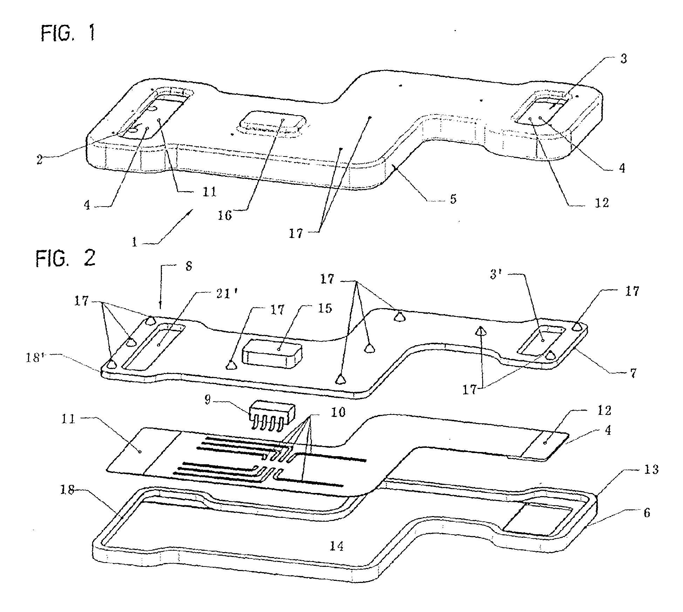

In Fig. 1 ist eine elektrische Leiterbahneneinheit 1 gezeigt, die eine über Fenster 2, 3 zu kontaktierende Leiterbahnfolie 4 in einem Kunststoff 5 eingebettet enthält. Dabei wird das Kunststoffmaterial in einem Spritzgussvorgang um die Leiterbahnfolie 4 herum gespritzt, und zu diesem Zweck wird beim Spritzvorgang die Leiterbahnfolie 4 durch ein Versteifungselement versteift und somit stabilisiert und gegen ein Verschwimmen im Spritzgusswerkzeug gehalten, wobei auch ein lokales Ausbiegen und Brechen bzw. Reißen der Leiterbahnfolie 4 vermieden wird.

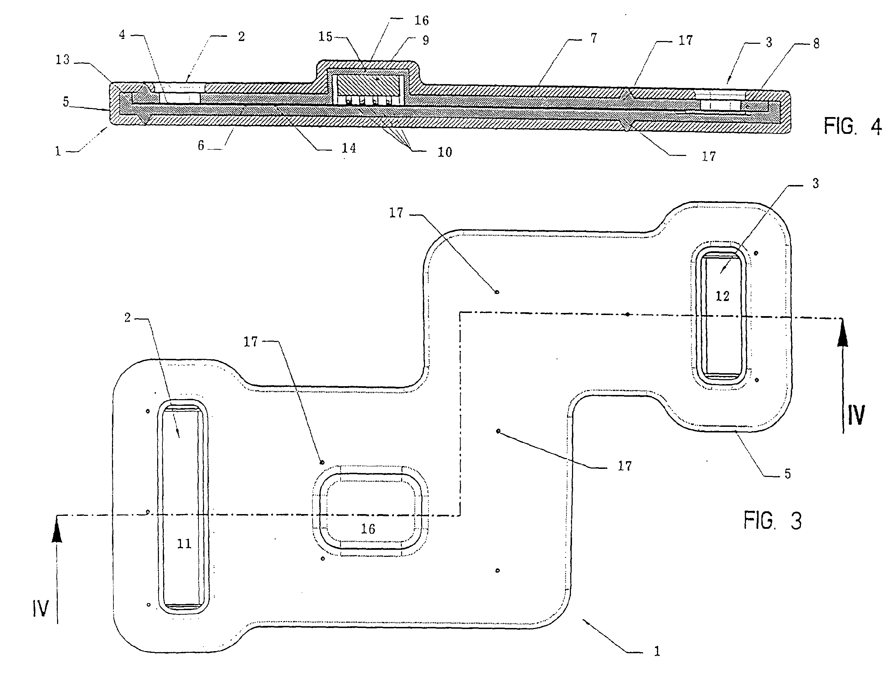

Im Einzelnen wird, wie aus Fig. 2 ersichtlich ist, ein Versteifungselement in Form eines aus zwei Teilen 6, 7 bestehenden Gehäuses 8 vorgesehen, wobei die Leiterbahnfolie 4 zwischen diesen beiden Gehäuseteilen 6, 7 aufgenommen, d.h. eingeschlossen wird, vgl. auch die Darstellung in Fig. 4. Im in Fig. 2 und 4 gezeigten Ausführungsbeispiel ist der Einfachheit halber nur ein elektrisches Bauelement, z.B. eine SMD-Komponente 9, veranschaulicht, die auf der Leiterbahnfolie 4 angelötet oder durch vercrimpen befestigt wird, wobei elektrische Kontakte zu Leiterbahnen 10 auf der beispielsweise aus einer Polyesterfolie oder einer Polyimidfolie bestehenden Leiterbahnfolie 4 hergestellt werden. Die Leiterbahnen 10 setzen sich zu in Fig. 2 nicht näher veranschaulichten Kontaktflächen in Endbereichen 11, 12 der Leiterbahnfolie 4 fort, und diese Endbereiche 11, 12 sind durch die Kontaktfenster 4 hindurch bei der fertigen Leiterbahneneinheit 1 (s. Fig. 1) kontaktierbar, was an sich jedoch herkömmliche Technik ist und hier nicht näher erläutert werden braucht.

Der eine Gehäuseteil 6 ist mehr oder weniger wannenförmig ausgebildet, um das Einlegen der Leiterbahnfolie 4 in den dadurch vorgesehenen Innenraum oder Aufnahmeraum zu ermöglichen, wobei die Formen der Gehäuseteile 6, 7 im Wesentlichen, sieht man vom hochstehenden Rand 13 des wannenförmigen Gehäuseteils 6 ab, der Form der Leiterbahnfolie 4 entsprechen. Über der Leiterbahnfolie 4 wird sodann der deckelförmige obere Gehäuseteil 7 in den unteren Wannen-Gehäuseteil 6 eingelegt, s. außer Fig. 2 auch Fig. 4. Der Innenraum im Gehäuse 8 für die Aufnahme der Leiterbahnfolie 4 ist dabei in Fig. 4 ebenso wie in Fig. 2 mit 14 bezeichnet. Aus Fig. 2 und 4 ist weiters auch ersichtlich, dass der obere Deckel-Gehäuseteil 7 mit einer Aufnahme 15 in Form einer Schutzhaube geformt ist, um einen Schutzraum für den Bauteil 9 zu schaffen. Nach dem Umspritzen des Gehäuses 8 im zusammengefügten Zustand, mit der darin eingelegten Leiterbahnfolie 4, s. Fig. 4, mit dem Kunststoffmaterial 5 wird ein Modul mit einer Ausbuchtung 16 an der Stelle dieser Schutzhaube 15 erhalten, wie aus Fig. 1, aber auch aus Fig. 3 und 4 ersichtlich ist. Dabei kann das Kunststoffmaterial an der Oberseite der Schutzhaube 15 im Bereich der Ausbuchtung 16 außerordentlich dünnwandig sein, um so im Fall, dass es sich bei dem eingeschlossenen Bauteil 9 um einen Sensor, wie etwa einen Hall-Sensor, handelt, für diesen eine hohe Ansprech-Empfindlichkeit gegenüber Einwirkungen von außen (die zu erfassen sind) sicherzustellen. Weiters ist aus Fig. 2 und 4 ersichtlich, dass die beiden Gehäuseteile 6, 7 an ihrer jeweiligen Außenseite mit Distanzelementen 17 in Form von Noppen geformt sind (die am unteren Gehäuseteil 6 an der Unterseite vorgesehenen Noppen-Distanzelemente 17 sind in Fig. 4 ersichtlich, wogegen in Fig. 2 die Unterseite zur Folge der schaubildlichen Darstellung verdeckt ist); diese Distanzelemente 17 dienen dazu, das Gehäuse 8 mit der in seinem Innenraum 14 eingelegten Leiterbahnfolie 4 (sowie mit daran angebrachten Bauteilen, wie dem Bauteil 9) in definiertem Abstand von den Werkzeug-Innenflächen zu halten, wenn der Umspritzvorgang durchgeführt wird. Demgemäß haben diese Distanzelemente 17 auch vorzugsweise alle dieselbe Höhe, und sie schließen bei der fertig gespritzten Leiterbahneneinheit 1 bündig mit der äußeren Oberfläche der Kunststoffummantelung 5 ab, wie insbesondere aus Fig. 4 zu ersehen ist, wie aber auch in Fig. 1 durch die punktförmig angedeuteten Spitzen der kegeligen Noppen-Distanzelemente 17 angedeutet ist.

Wie weiters in Fig. 2 und 4 gezeigt ist, hat der obere Deckel-Gehäuseteil 7 entsprechende Fenster 2', 3', wobei diese Fenster 2', 3' beim Umspritzen mit Kunststoff freigehalten werden, um so bei der fertigen Leiterbahneneinheit 1 die bereits erwähnten Fenster 2, 3 für die Kontaktierung der Leiterbahnfolie 4 zu erhalten. Hierzu ist das Spritzgusswerkzeug mit entsprechenden Vorsprüngen zu versehen.

Wie unmittelbar zu ersehen ist, schützt das Gehäuse 8 die Leiterbahnfolie 4 während des Umspritzvorganges verlässlich, ebenso wie es an der Leiterbahnfolie 4 angebrachte elektrische bzw. elektronische oder elektromechanische Bauteile, wie die genannte SMD-Komponente 9, schützt. Dadurch wird erreicht, dass die Leiterbahnfolie 4 ebenso wie die Bauteile 9 nicht dem Druck und der Temperatur des Kunststoffmaterials ausgesetzt werden, sondern im Wesentlichen nur einen reduzierten Druck und nur Werkzeugtemperatur aushalten müssen. Dementsprechend können auch weniger temperaturbeständige Bauteile 9 und Folienmaterialien verwendet werden. Es können für die Leiterbahnfolie 4 praktisch alle marktüblichen Folien eingesetzt werden, wie insbesondere preiswerte Polyesterfolien, wenngleich selbstverständlich auch kostenaufwendigere Polyimidfolien ebenso verwendbar sind. Als Material für die Kunststoffumspritzung 5 können, abgesehen davon, dass auch Duroplaste verwendet werden können, bevorzugt alle herkömmlichen Thermoplaste eingesetzt werden, wie insbesondere Polybutylenterephthalat (PBT) und Polypropylen (PP).

In Abwandlung der gezeigten Ausführung des Gehäuses 8 mit zwei als gesonderte Teile vorgefertigten Gehäuseteilen 6, 7 ist es auch denkbar, die beiden Gehäuseteile 6, 7 in einem Stück vorzufertigen, wobei sie längs einer Kante, z.B. der Kante 18 bzw. 18' in Fig. 2, über ein nicht näher veranschaulichtes Filmscharnier miteinander verbunden und somit ineinander klappbar sein können. Auch diese vorgefertigten Gehäuseteile 6, 7 können aus den genannten Kunststoffmaterialien, insbesondere Thermoplasten, wie PBT und PP, im Vorhinein gespritzt werden.

Andererseits ist es aber auch möglich, die Gehäuseteile bzw. allgemein die Versteifungselemente aus Metall bzw. Metallblech vorzufertigen, vor allem da üblicherweise die Leiterbahnfolien 4 eine Decklackbeschichtung aufweisen, so dass die notwendige elektrische Isolierung dadurch gesichert ist.

Der Vollständigkeit halber sei noch erwähnt, dass selbstverständlich, auch wenn in den Fig. 1 bis 4 eine sehr einfache Leiterbahnfolie 4 mit bloß einem daran angebrachten Bauteil 9 veranschaulicht ist, die Formen und Strukturen der Leiterbahnfolie 4 und der Leiterbahnen 10 wesentlich komplexer sein können, wobei auch eine Mehrzahl von Bauteilen 9 an der Leiterbahnfolie durch Verlöten oder Vercrimpen angebracht werden kann, bevor der Umspritzvorgang stattfindet.

In Abwandlung der beschriebenen Ausführungsform ist es weiters auch denkbar, die Leiterbahnfolie 4 an einem einfachen Versteifungselement, beispielsweise entsprechend dem oberen Gehäuseteil 7 oder aber entsprechend dem unteren Gehäuseteil 6, anzubringen. Auch dadurch würde, bei entsprechender Anlage der Leiterbahnfolie 4 an diesem Versteifungselement 6 oder 7, ein unerwünschtes Ausbiegen und Reißen bzw. Verschwimmen in der Werkzeugform vermieden werden. Zum Festhalten der Leiterbahnfolie 4 an einem derartigen Versteifungselement in Form einer im Wesentlichen kongruenten steifen Platte, eines Blechs oder dergl. könnten über die Fläche einer Leiterbahnfolie 4 bzw. des Versteifungselements 6 oder 7 verteilt mehrere Haftpunkte bzw. Klebstoffpunkte vorgesehen sein. Auch können in der Leiterbahnfolie 4 Löcher und am Versteifungselement 6 oder 7 dazu passende Noppen vorgesehen sein, über die die Leiterbahnfolie mit den Öffnungen geschnappt wird, so dass ein eng anliegender Sitz der Leiterbahnfolie am Versteifungselement sichergestellt wird. Eine weitere Modifikation bestünde darin, beim unteren Gehäuseteil 6 den Rand 13 wegzulassen und so die Leiterbahnfolie 4 zwischen zwei plattenförmigen Elementen einzu"schließen".

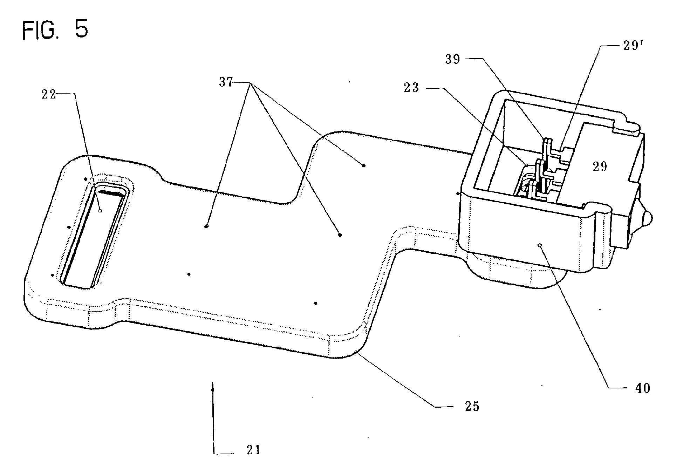

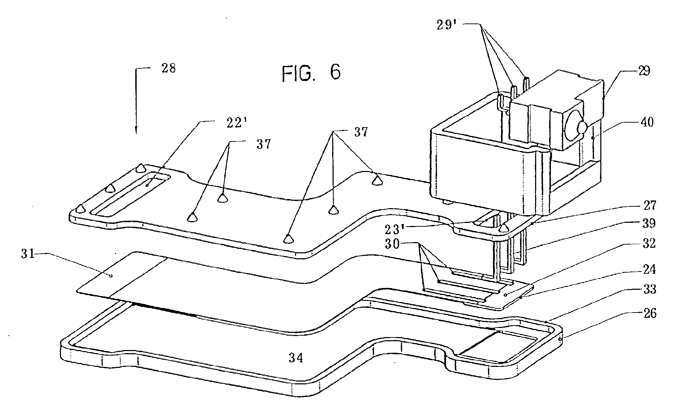

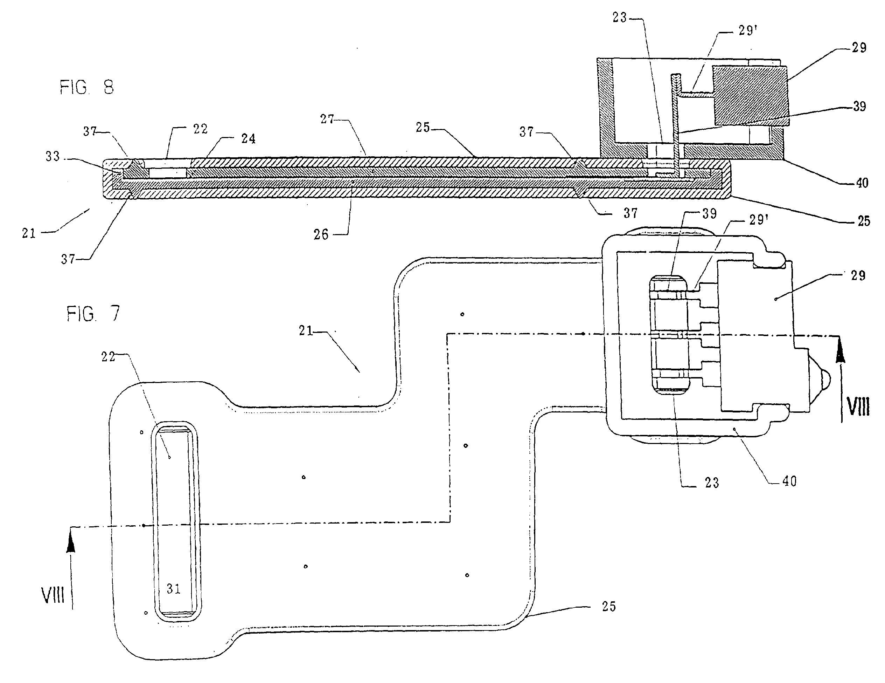

In den Fig. 5 bis 8 ist in Darstellungen im Wesentlichen entsprechend den vorstehend erläuterten Fig. 1 bis 4 eine andere Ausführungsform der Erfindung gezeigt, bei der wiederum die Leiterbahneneinheit 21 durch Umspritzen einer Leiterbahnfolie 24, die in einem Gehäuse 28 eingelegt ist, erhalten wird. Dabei sind wiederum zwei Fenster 22, 23 zur Kontaktierung der Leiterbahnen 30 (s. Fig. 6) auf der Leiterbahnfolie 24 vorgesehen, wobei entsprechende Fenster-Öffnungen 22', 23' im einen, oberen Gehäuseteil 27 des wiederum zweiteilig ausgeführten Gehäuses 28 vorhanden sind. Dieser obere Gehäuseteil 27 ist wieder als Deckel passend in den Innenraum oder Aufnahmeraum 34 des unteren wannenförmigen Gehäuseteils 26 vorgefertigt, wobei zwischen den beiden Gehäuseteilen 27, 26 die Leiterbahnfolie 24 eingelegt wird (s. insbesondere auch Fig. 8). Dabei weist der untere, wannenförmige Gehäuseteil 26 wiederum einen hochstehenden Rand 33 auf.

Die Leiterbahnfolie 24 ist mit Endabschnitten 31, 32 in den Fenstern 22, 23 zugänglich, und weiters weisen beide Gehäuseteile 26, 27 kegelige, noppenförmige Distanzelemente 27 zum Halten des Gehäuses 28 samt Leiterbahnfolie 24 im Spritzgusswerkzeug auf, wenn das Gehäuse 28 mit der eingelegten Leiterbahnfolie 24, letzte durch das Gehäuse 28 versteift, in ein Spritzgusswerkzeug eingelegt wird, um darin mit Kunststoff umspritzt zu werden, s. die Kunststoffumspritzung 25 in Fig. 5, 7 und 8.

Insoweit entspricht das Ausführungsbeispiel gemäß Fig. 5 bis 8 jenem gemäß Fig. 1 bis 4.

Bei der Leiterbahneneinheit 21 gemäß Fig. 5 bis 8 ist sodann weiters ein von außen zugänglicher elektrischer oder elektromechanischer Bauteil, hier beispielsweise in Form eines Mikroschalters 29, vorgesehen, der über Anschlüsse 29' mit Kontaktfahnen 39 elektrisch verbunden wird, beispielsweise durch Schweißen oder aber auch durch Löten; diese Kontaktfahnen 39 sind ihrerseits mit ihren unteren abgewinkelten Enden mit den Leiterbahnen 30 der Leiterbahnfolie 24 durch das eine Fenster 23 bzw. 23' hindurch kontaktiert, beispielsweise durch Anlöten oder durch Crimpen, wie dies an sich bekannt ist. Zur Fixierung des Bauteils bzw. Mikroschalters 29 dient ein eigener Aufnahmeteil 40, in dem der Bauteil 29 klemmend festgehalten wird, und der an seiner Bodenseite eine nicht näher bezeichnete Öffnung in Ausrichtung zum Fenster 23, für den Durchtritt der Kontaktfahnen 39, hat. Dieser Aufnahmeteil 40 kann ein vorgefertigter Spritzgussteil sein, der beim Umspritzen des Gehäuses 28 mit der eingelegten Leiterbahnfolie 24 mit angespritzt wird. Dabei ist es auch denkbar, den Innenraum des Aufnahmeteils 40 mit Kunststoffmaterial auszufüllen, um so die Kontaktfahnen 39 dicht einzuschließen. In Abwandlung hievon ist es aber weiters auch möglich, anstatt eines vorgefertigten Aufnahmeteils 40 direkt einen Aufnahmeteil 40 aus Kunststoff zu spritzen, wenn das Gehäuse 28 mit der Leiterbahnfolie 24 umspritzt wird, um so den Bauteil 29 in die Leiterbahneneinheit 21 mit Hilfe eines einheitlichen Kunststoff-Einbettungsmaterials 25 zu integrieren.

Selbstverständlich können auch bei der Ausführungsform gemäß Fig. 5 bis 8 weitere elektrische bzw. elektronische Bauteile an der Leiterbahnfolie 24 angebracht und durch eine Schutzhaube ähnlich der Schutzhaube 15 gemäß Fig. 2 und 4 beim Umspritzen mit dem Kunststoffmaterial abgedeckt werden.

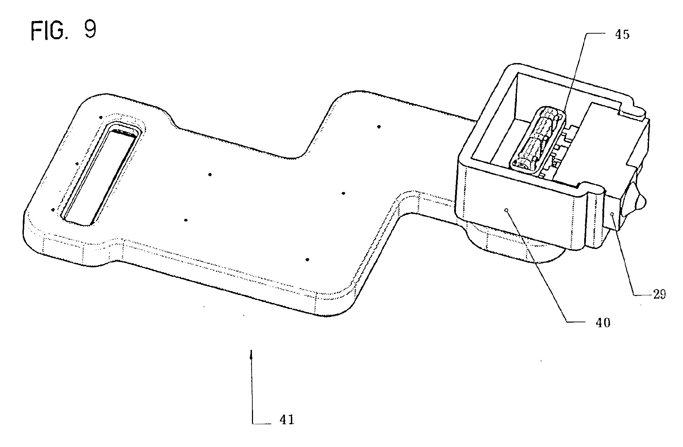

Dies gilt auch für die Ausführungsform gemäß Fig. 9 bis 12, die weitestgehend jener gemäß Fig. 5 bis 8 gleicht, so dass demgegenüber nur die Unterschiede im Zusammenhang mit der Anbringung des als elektromechanischer Bauteil 29 vorgesehenen Mikroschalters bzw. dessen elektrischer Verbindung mit der Leiterbahnfolie 24 erläutert werden sollen. Soweit im Übrigen erforderlich, werden Elemente, die solchen gemäß Fig. 5 bis 8 entsprechen, mit den selben Bezugszeichen wie in Fig. 5 bis 8 bezeichnet.

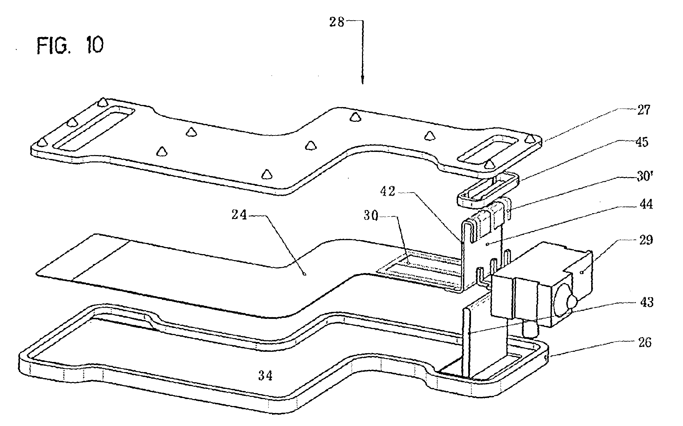

Bei der Leiterbahneneinheit 41 gemäß Fig. 9 bis 12 ist die Leiterbahnfolie 24 mit ihrem in den Fig. 9 bis 12 rechten Endbereich 42 um 90° nach oben abgewinkelt und dann um 180° zurück abgebogen, so dass sie mit diesem abgebogenen Bereich 42 über einen stegförmigen Vorsprung 43 des unteren Gehäuseteils 26 geschoben werden kann, wenn sie in den Aufnahmeraum 34 des unteren, wannenförmigen Gehäuseteils 26 eingelegt wird. Danach wird der obere, deckelförmige Gehäuseteil 27 wie in den beiden vorstehenden Ausführungsformen auf- bzw. eingesetzt. Der umgebogene Endbereich 42 kann dabei auch wie aus Fig. 10 ersichtlich mit einer Verstärkungsauflage 44 auf der von den Leiterbahnen 30 abgewandten Seite versehen sein.

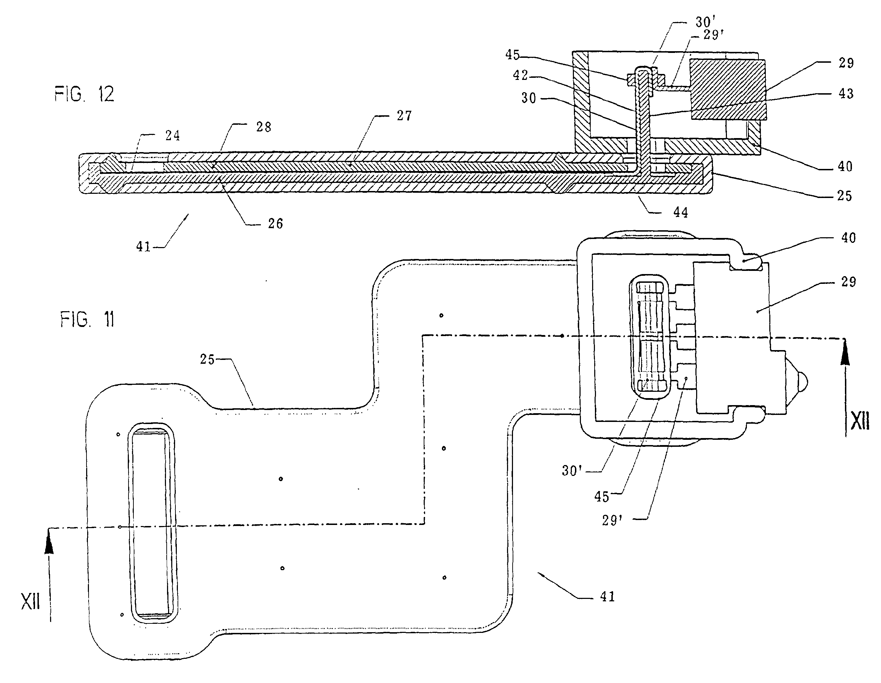

Beim Umspritzen des Gehäuses 28 mit der darin eingelegten und gegen Ausbiegen gesicherten Leiterbahnfolie 24 mit dem Kunststoffmaterial 25 kann wiederum ein Aufnahmeteil 40 für den Bauteil 29 (Mikroschalter) durch Anspritzen fixiert werden, wobei im Inneren dieses Aufnahmeteils 40 der stegförmige Vorsprung 43 samt dem abgewinkelten Endbereich 42 der Leiterbahnfolie 24 hochragt. In den Aufnahmeteil 40 wird sodann der Bauteil 29 eingesetzt, wobei seine Anschlüsse 29' mit den Enden 30' der Leiterbahnen 30 auf dem umgebogenen Endbereich 42 der Leiterbahnfolie 24 in Kontakt gelangen, wie dies insbesondere aus Fig. 12 ersichtlich ist. Im Anschluss daran wird zur gegenseitigen Klemmung der Leiterbahnbereiche 30' und der Anschlüsse 29' ein Sicherungsring 45 im Kontaktbereich aufgeschoben, wie dies ebenfalls am deutlichsten aus Fig. 12, aber auch aus Fig. 9 hervorgeht. Anstatt dieser mechanischen Sicherung mit dem in Draufsicht ungefähr rechteckigen Ring 45 kann jedoch auch ein Vergießen bzw. Einspritzen von Kunststoffmaterial vorgesehen werden, wobei es im Weiteren auch denkbar ist, auf einen gesonderten vorgefertigten Aufnahmeteil 40 zu verzichten und direkt den Bauteil 29 beim Fertigspritzen der Leiterbahneneinheit 41 mit dem eingespritzten Kunststoffmaterial an der übrigen Leiterbahneneinheit 41 zu fixieren.

Selbstverständlich können auch beliebige andere elektrische, elektronische oder elektromechanische Bauteile an der Leiterbahneneinheit angebracht werden, wie Stecker, Sensoren, kleine Motoren usw., je nach Anwendungszweck. Als Einsatzgebiet für die vorliegenden Leiterbahneneinheiten, bestückt mit Bauteilen, sind insbesondere Türschlosseinheiten von Kraftfahrzeugen und dergl. zu nennen, wo es auf eine optimale Abdichtung gegenüber äußeren Einflüssen, wie Wasser, ankommt.

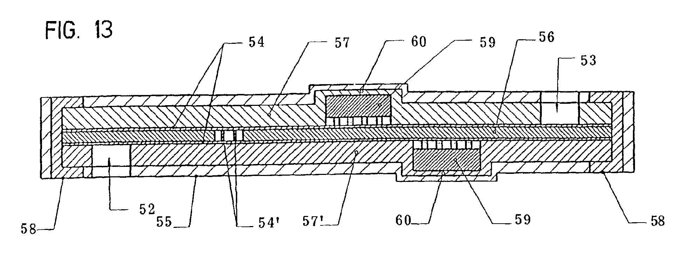

In Fig. 13 ist eine elektrische Leiterbahneneinheit 51 mit einer Sandwichstruktur veranschaulicht, wobei beispielsweise zwei über Fenster 52, 53 von verschiedenen Seiten her kontaktierbare Leiterbahnfolien 54 angeordnet sind, die miteinander über Kontaktfahnen 54' in Verbindung stehen. Diese Kontaktfahnen 54' sind in einer Öffnung in einem mittleren plattenförmigen Versteifungselement 56 vorgesehen, und an der Außenseite wird die Sandwichstruktur durch zwei weitere plattenförmige Verstärkungselemente 57, 57' abgeschlossen. Diese Einheit bestehend aus Leiterbahnfolien 54 und Versteifungselementen 56, 57, 57' kann beispielsweise für den Umspritzvorgang, vgl. das Kunststoffmaterial 55, mit Hilfe von randseitigen vorgefertigten Kunststoffklammern 58 zusammengehalten werden, welche zugleich als Distanzelemente zur Abstandshalterung im Spritzgusswerkzeug dienen können.

Schematisch sind in Fig. 13 weiters zwei mit den Leiterbahnfolien 54 elektrisch verbundene Bauelemente 59 gezeigt, wobei selbstverständlich die Zahl und Anordnung dieser Bauelemente variieren kann. Die Bauelemente 59 sind wiederum unter an den plattenförmigen Versteifungselementen 57, 57' ausgeformten Schutzhauben 60 geschützt angeordnet, wenn die Sandwichstruktur mit dem Kunststoffmaterial 55 umspritzt wird.

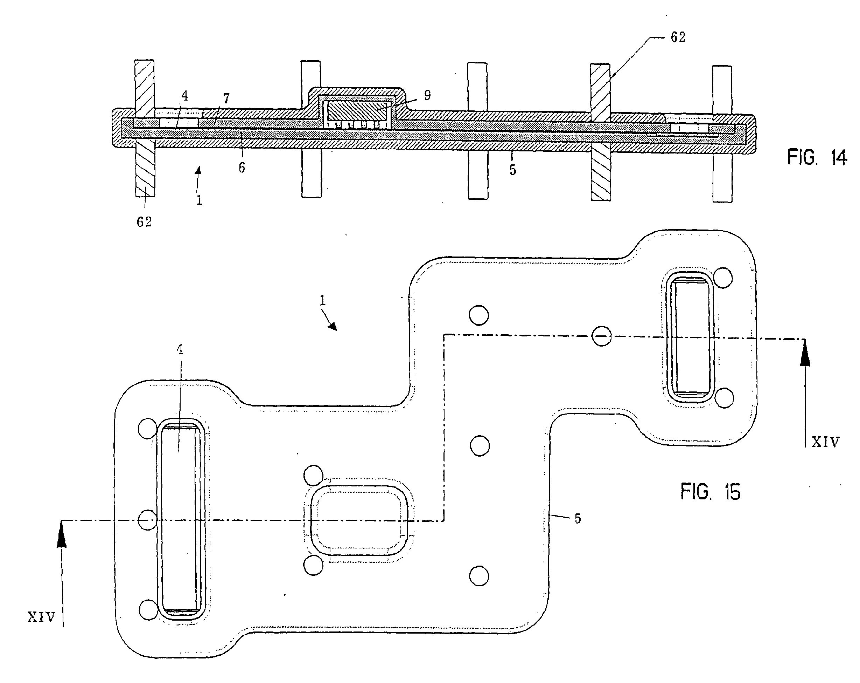

Bei den vorstehenden Ausführungsbeispielen, etwa jenem gemäß Fig. 1 bis 4, wurden in die jeweilige Leiterbahneneinheit integrierte Distanzelemente, wie die noppenförmigen Distanzelemente 17 gemäß Fig. 1 bis 4, erläutert. Zusätzlich oder anstatt dessen können aber auch werkzeugseitige Abstandshalter verwendet werden, und ein derartiges Ausführungsbeispiel ist schematisch in den Fig. 14 und 15 in einer Schnittansicht gemäß der Linie XIV-XIV in Fig. 15 bzw. in einer Draufsicht gezeigt. Es handelt sich dabei im Wesentlichen um die Leiterbahneneinheit gemäß Fig. 1 bis 4, mit den zwei Gehäuseteilen 6, 7 als Versteifungselementen, wobei zwischen diesen beiden Gehäuseteilen 6 und 7 die Leiterbahnfolie 4 eingelegt ist. Diese Einbettungseinheit, bestehend aus den Teilen 4, 6 und 7, zusammen mit z.B. einem elektronischen Bauteil 9, wird mit Kunststoff 5 umspritzt, wobei zur Halterung der Einbettungseinheit 4, 6, 7, 9 im Spritzgusswerkzeug (das in Fig. 14 und 15 nicht näher veranschaulicht ist) werkzeugseitige Abstandshalter in Form von Stützkernen 62 vorgesehen sind, die außen an den Gehäuseteilen 6 bzw. 7 anliegen und dabei von den Werkzeugflächen des Spritzgusswerkzeuges vorstehen. Beim fertigen, umspritzten Produkt, d.h. der Leiterbahneneinheit 1, verbleiben dann an der Stelle dieser Stützkerne 62 entsprechende Löcher, wenn die Stützkerne 62 im Werkzeug zurückgezogen werden und die Leiterbahneneinheit 1 aus dem Werkzeug entnommen wird. Nichtsdestoweniger ist bei der fertigen Leiterbahneneinheit 1 durch die Umspritzung in Verbindung mit den Gehäuseteilen 6, 7 die gewünschte Dichtheit für die Leiterbahnfolie 4 gewährleistet.

## Patentansprüche

1. Verfahren zum Einbetten zumindest einer flexibl.en Leiterbahnfolie in Kunststoff, **dadurch gekennzeichnet, dass** die flexible Leiterbahnfolie (4; 24; 54) an bzw. in einem sie gegen ein Verbiegen sichernden vorgefertigten Versteifungselement (6, 7; 26, 27 ; 56, 57, 57') angebracht und zusammen mit diesem Versteifungselement mit Kunststoff umspritzt wird.

2. Verfahren nach Anspruch 1, **dadurch gekennzeichnet, dass** an der flexiblen Leiterbahnfolie vor dem Umspritzen zumindest ein z.B. elektrischer oder elektromechanischer Bauteil (9; 29; 59), wie ein Sensor oder Mikroschalter, angebracht wird.

3. Verfahren nach Anspruch 2, **dadurch gekennzeichnet, dass** das Versteifungselement (7; 57, 57') mit einer Aufnahme (15; 60) für den Bauteil (9; 59) vorgefertigt wird.

4. Verfahren nach Anspruch 3, **dadurch gekennzeichnet, dass** die Aufnahme (15; 60) haubenförmig geformt wird.

5. Verfahren nach einem der Ansprüche 1 bis 4, **dadurch gekennzeichnet, dass** das versteifungselement (6, 7; 26, 27) mit Distanzelementen (17; 37) vorgefertigt wird, um das Versteifungselement im Spritzgusswerkzeug in Abstand von dessen Formfläche zu halten.

6. verfahren nach einem der Ansprüche 1 bis 5, **dadurch gekennzeichnet, dass** beim Umspritzen des Versteifungselements (6, 7) samt Leiterbahnfolie (4) im Spritzgusswerkzeug Stützkerne (62) verwendet werden, um das Versteifungselement (6, 7) in Abstand von den Formflächen des Spritzgusswerkzeuges zu halten.

7. Verfahren nach einem der Ansprüche 1 bis 6, **dadurch gekennzeichnet, dass** zumindest zwei flexible Leiterbahnfolien (54) mit zugehörigen Versteifungselementen (56, 57, 57') in einer Sandwichbauweise übereinander angeordnet und mit Kunststoff (55) umspritzt werden.

8. Verfahren nach einem der Ansprüche 1 bis 7, **dadurch gekennzeichnet, dass** die Leiterbahnfolie (4; 24; 54) samt Versteifungselement (6, 7; 26, 27; 56, 57, 57') mit einem thermoplastischen Kunststoff (5; 25; 55), z.B. PBT (Polybutylenterephthalat) oder PP (Polypropylen), umspritzt wird.

9. Verfahren nach einem der Ansprüche 1 bis 8, **dadurch gekennzeichnet, dass** beim Umspritzen am Versteifungselement (27) zumindest ein Aufnahmeteil (40) für einen Bauteil (29), z.B. einen Mikroschalter, mitgespritzt wird.

10. Verfahren nach einem der Ansprüche 1 bis 9, **dadurch gekennzeichnet, dass** die flexible Leiterbahnfolie (24) vor dem Umspritzen mit Kunststoff bereichsweise umgebogen und mit diesem umgebogenen Bereich (42) an einem Vorsprung (43) des versteifungselements (26) fixiert wird.

11. Verfahren nach Anspruch 10, **dadurch gekennzeichnet, dass** zur Sicherung des umgebogenen Bereichs (42) der flexiblen Leiterbahnfolie (24) am Vorsprung (43) des Versteifungselements (26) nach dem Umspritzen mit Kunststoff unter Freilassung dieses Bereichs ein Ringelement (45) auf den umgebogenen Bereich (42) unter Klemmung aufgeschoben wird.

12. Verfahren nach einem der Ansprüche 1 bis 11, **dadurch gekennzeichnet, dass** als Versteifungselement ein Gehäuse (8; 28) mit einem Innenraum (14; 34) vorgefertigt wird, in dem die flexible Leiterbahnfolie (4; 24) vor dem Umspritzen angebracht wird.

13. Verfahren nach Anspruch 12, **dadurch gekennzeichnet, dass** das Gehäuse (8; 28) in zwei Teilen (6, 7; 26, 27), vorzugsweise mit einem Wannenteil und einem Deckelteil, vorgefertigt wird.

14. Verfahren nach Anspruch 13, **dadurch gekennzeichnet, dass** die beiden Gehäuseteile (6, 7; 26, 27) als separate Teile vorgefertigt werden.

15. Verfahren nach Anspruch 13, **dadurch gekennzeichnet, dass** die beiden Gehäuseteile (6, 7) über ein Filmscharnier verbunden einstückig vorgefertigt werden.

16. Elektrische Leiterbahneneinheit mit zumindest einer mit Kunststoff umspritzten Leiterbahnfolie, **dadurch gekennzeichnet, dass** die Leiterbähnfolie (4; 24) an bzw. in einem mit dem Kunststoff umspritzten Versteifungselement angeordnet ist.

17. Leiterbahneneinheit nach Anspruch 16, **dadurch gekennzeichnet, dass** das Versteifungselement (6, 7; 26, 27; 56, 57, 57') durch ein Gehäuse (8; 28) gebildet ist.

18. Leiterbahneneinheit nach Anspruch 17, **dadurch gekennzeichnet, dass** im Gehäuse (8; 28) und in der Kunststoff-Einbettung (5; 25) Fenster (2, 3; 22, 23) zur Kontaktierung von leitenden Kontaktflächen der Leiterbahnfolie (4; 24) freigelassen sind.

19. Leiterbahneneinheit nach Anspruch 17 oder 18, **dadurch gekennzeichnet, dass** das Gehäuse (8) eine haubenförmige Aufnahme (15) aufweist, in der ein mit der Leiterbahnfolie (4) verbundener Bauteil (9) angeordnet ist.

20. Leiterbahneneinheit nach einem der Ansprüche 17 bis 19, **dadurch gekennzeichnet, dass** aus dem Einbettungs-Kunststoffmaterial (25) ein vom Gehäuse (28) gesonderter Aufnahmeteil (40) gebildet ist, in dem ein Bauteil (29) angeordnet ist.

21. Leiterbahneneinheit nach einem der Ansprüche 17 bis 20, **dadurch gekennzeichnet, dass** das Gehäuse (8; 28) außen mit z.B. noppenförmigen Distanzelementen (17; 37) ausgebildet ist, die im Kunststoffmaterial (5; 25) bündig mit dessen Außenfläche abschließend eingebettet sind.

22. Leiterbahneneinheit nach einem der Ansprüche 16 bis 21, **dadurch gekennzeichnet, dass** in Kunststoff auch wenigstens ein, z.B. elektrischer oder elektromechanischer Bauteil eingebettet ist.

23. Einbettungseinheit zum Umspritzen mit Kunststoff gemäß einem Verfahren nach einem der Ansprüche 12 bis 15, **gekennzeichnet durch** ein vorgefertigtes Gehäuse (8; 28) mit zwei zusammenpassenden Gehäuseteilen (6, 7; 26, 27), zwischen denen im zusammengefügten Zustand ein Aufnahmeraum (14; 34) zum Einschließen einer Leiterbahnfolie (4; 24) zwischen den Gehäuseteilen vorgesehen ist.

24. Einbettungseinheit nach Anspruch 23, **dadurch gekennzeichnet, dass** zumindest ein Gehäuseteil (7) mit zumindest einem Fenster (2', 3') für die Kontaktierung der Leiterbahnfolie (4) ausgebildet ist.

25. Einbettungseinheit nach Anspruch 23 oder 24, **dadurch gekennzeichnet, dass** beide Gehäuseteile (6, 7; 26, 27) außen mit z.B. noppenförmigen Distanzelementen (17; 37) geformt sind.

26. Einbettungseinheit nach einem der Ansprüche 23 bis 25, **dadurch gekennzeichnet, dass** zumindest ein Gehäuseteil (26) mit einem z.B. stegförmigen Vorsprung (43) geformt ist, der im zusammengefügten Zustand der Gehäuseteile (26, 27) durch ein Fenster des anderen Gehäuseteils (27) ragt.

## Claims

1. A method for embedding at least one flexible conductor track foil in a plastics material, **characterized in that** the flexible conductor track foil (4; 24; 54) is attached to or in a prefabricated stiffening element (6, 7; 26, 27; 56, 57, 57') securing the same against bending, and together with the stiffening element is injection-molded around with plastics material.

2. The method according to claim 1, **characterized in that** at least one, e.g. electrical or electromechanical, component (9; 29; 59) such as a sensor or micro-switch is attached to the flexible conductor track foil prior to injection-molding around.

3. The method according to claim 2, **characterized in that** the stiffening element (7; 57, 57') is prefabricated to include a reception means (15; 60) for the component (9; 59).

4. The method according to claim 3, **characterized in that** the reception means (15; 60) is hood-shaped.

5. The method according to any one of claims 1 to 4, **characterized in that** the stiffening element (6, 7; 26, 27) is prefabricated to include spacer elements (17; 37) for holding the stiffening element in the injection-molding tool at a distance from the molding surfaces of the same.

6. The method according any one of claims 1 to 5, **characterized in that**, when injection-molding around the stiffening element (6, 7) plus conductor track foil (4), supporting cores (62) are used in the injection-molding tool to keep the stiffening element (6, 7) at a distance from the molding surfaces of the injection-molding tool.

7. The method according any one of claims 1 to 6, **characterized in that** at least two flexible conductor track foils (54) with associated stiffening elements (56, 57, 57') are superimposed in a sandwich-like manner and injection-molded around with plastics material (55).

8. The method according any one of claims 1 to 7, **characterized in that** the conductor track foil (4; 24; 54) plus stiffening element (6, 7; 26, 27; 56, 57, 57') are injection-molded around with a thermoplastic material (5; 25; 55), e.g. PBT (polybutylene terephthalate) or PP (polypropylene).

9. The method according to any one of claims 1 to 8, **characterized in that**, on the stiffening element (27), at least one reception part (40) for a component (29), e.g. a micro-switch, is injection-molded along when injection-molding around.

10. The method according to any one of claims 1 to 9, **characterized in that** the flexible conductor track foil (24), prior to being injection-molded around with plastics material, is bent in a certain region and fixed to a projection (43) of the stiffening element (26) with this bent region (42).

11. The method according to claim 10, **characterized in that**, for securing the bent region (42) of the flexible conductor track foil (24) to the projection (43) of the stiffening element (26) after injection-molding around with plastics material while leaving free said region, a ring element (45) is slipped onto the bent region (42) by clamping.

12. The method according to any one of claims 1 to 11, **characterized in that** a casing (8; 28) having an inner space (14; 34) in which the flexible conductor track foil (4; 24) is fastened prior to injection-molding around is prefabricated as said stiffening element.

13. The method according to claim 12, **characterized in that** the casing (8; 28) is prefabricated in two parts (6, 7; 26, 27), preferably comprising a trough-shaped part and a lid part.

14. The method according to claim 13, **characterized in that** the two casing parts (6, 7; 26, 27) are prefabricated as separate parts.

15. The method according to claim 13, **characterized in that** the two casing parts (6, 7; 26, 27) are prefabricated in one piece by being connected via a film hinge.

16. An electrical conductor track unit including at least one plastics-embedded conductor track foil, **characterized in that** the conductor track foil (4; 24) is arranged on or in a stiffening element injection-molded around with said plastics material.

17. The conductor track unit according to claim 16, **characterized in that** the stiffening element (6, 7; 26, 27; 56, 57, 57') is formed by a casing (8; 28).

18. The conductor track unit according to claim 17, **characterized in that** windows (2, 3; 22, 23) are kept clear in the casing (8; 28) and in the plastics embedding (5; 24) for contacting conductive contact surfaces of the conductor track foil (4; 24).

19. The conductor track unit according to claim 17 or 18, **characterized in that** the casing (8) comprises a hood-shaped reception means (15), in which a component (9) connected with the conductor track foil (4) is arranged.

20. The conductor track unit according to any one of claims 17 to 19, **characterized in that** a reception part (40) separate from the casing (28) is formed by the plastics embedding material (25), in which reception part a component (29) is arranged.

21. The conductor track unit according to any one of claims 17 to 20, **characterized in that** the casing (8; 28) is externally provided with, e.g. knob-shaped, spacer elements (17; 37) which are embedded in the plastics material (5; 25) so as to end flush with the outer surface therof.

22. The conductor track unit according to any one of claims 16 to 21, **characterized in that** also at least one, e.g. electrical or electromechanical, component is embedded in the plastics material.

23. An embedding unit to be injection-molded around with plastics material by a method according to any one of claims 12 to 15, **characterized by** a prefabricated casing (8; 28) comprising two matching casing parts (6, 7; 26, 27) between which, in the assembled state, a reception space (14; 34) is provided for enclosing a conductor track foil (4; 24) between the housing parts.

24. The embedding unit according to claim 23, **characterized in that** at least one casing part (7) is formed with at least one window (2', 3') for contacting the conductor track foil (4).

25. The embedding unit according to claim 23 or 24, **characterized in that** both of the casing parts (6, 7; 26, 27) are externally formed with, e.g. knob-shaped, spacer elements (17; 37).

26. The embedding unit according to any one of claims 23 to 25, **characterized in that** at least one casing part (26) is formed with an, e.g. web-shaped, projection (43) which, in the assembled state of the casing parts (26, 27), projects through a window of the respective other casing part (27).

## Revendications

1. Procédé pour enrober au moins un film de piste conductrice flexible en matière plastique, **caractérisé en ce que** le film de piste conductrice flexible (4 ; 24 ; 54) est placé sur ou dans un élément de renfort (6, 7 ; 26, 27, 56, 57, 57') préfabriqué et protégeant d'une torsion et est surmoulé avec une matière plastique en même temps que cet élément de renfort.

2. Procédé selon la revendication 1, **caractérisé en ce que**, avant le surmoulage, au moins un composant (9 ; 29 ; 59) par exemple électrique ou électromécanique, tel qu'un capteur ou un microrupteur, est placé sur le film de piste conductrice flexible.

3. Procédé selon la revendication 2, **caractérisé en ce que** l'élément de renfort (7 ; 57, 57') est préfabriqué avec un logement (15 ; 60) pour le composant (9 ; 59).

4. Procédé selon la revendication 3, **caractérisé en ce que** le logement (15 ; 60) est configuré en forme de capot.

5. Procédé selon l'une quelconque des revendications 1 à 4, **caractérisé en ce que** l'élément de renfort (6, 7 ; 26, 27) est préfabriqué avec des éléments d'espacement (17 ; 37), afin de maintenir l'élément de renfort dans l'outil de moulage par injection à distance de sa surface de moulage.

6. Procédé selon l'une quelconque des revendications 1 à 5, **caractérisé en ce que**, lors du surmoulage de l'élément de renfort (6, 7) avec le film de piste conductrice (4), des mandrins de soutien (62) sont utilisés dans l'outil de moulage par injection, afin de maintenir l'élément de renfort (6, 7) à distance des surfaces de moulage de l'outil de moulage par injection.

7. Procédé selon l'une quelconque des revendications 1 à 6, **caractérisé en ce qu'**au moins deux films de piste conductrice (54) flexibles sont disposés avec des éléments de renfort (56, 57, 57') spécifiques les uns au-dessus des autres dans une structure en sandwich et sont surmoulés avec une matière plastique (55).

8. Procédé selon l'une quelconque des revendications 1 à 7, **caractérisé en ce que** le film de piste conductrice (4 ; 24 ; 54) avec l'élément de renfort (6, 7 ; 26, 27 ; 56, 57, 57') est surmoulé avec une matière plastique thermoplastique (5 ; 25 ; 55), par exemple du PBT (polybutylènetéréphthalate) ou du PP (polypropylène).

9. Procédé selon l'une quelconque des revendications 1 à 8, **caractérisé en ce que**, lors du surmoulage sur l'élément de renfort (27), au moins une partie de logement (40) pour un composant (29), par exemple un microrupteur, est également injectée.

10. Procédé selon l'une quelconque des revendications 1 à 9, **caractérisé en ce que** le film de piste conductrice (24) flexible est replié par endroits avant le surmoulage avec une matière plastique et est fixé avec cette zone (42) repliée sur une saillie (43) de l'élément de renfort (26).

11. Procédé selon la revendication 10, **caractérisé en ce que**, pour sécuriser la zone (42) repliée du film de piste conductrice flexible (24) sur la saillie (43) de l'élément de renfort (26), un élément annulaire (45) est introduit avec serrage sur la zone (42) repliée après le surmoulage avec une matière plastique en laissant libre cette zone.

12. Procédé selon l'une quelconque des revendications 1 à 11, **caractérisé en ce qu'**un boîtier (8 ; 28) est préfabriqué comme élément de renfort avec un espace intérieur (14 ; 34), dans lequel le film de piste conductrice (4 ; 24) flexible est placé avant le surmoulage.

13. Procédé selon la revendication 12, **caractérisé en ce que** le boîtier (8 ; 28) est préfabriqué en deux parties (6, 7 ; 26, 27), de préférence avec une partie cuve et une partie couvercle.

14. Procédé selon la revendication 13, **caractérisé en ce que** les deux parties der boîtier (6, 7 ; 26, 27) sont préfabriquées sous forme de parties séparées.

15. Procédé selon la revendication 13, **caractérisé en ce que** les deux parties de boîtier (6, 7) sont préfabriquées d'un seul tenant, reliées au moyen d'une charnière en film.

16. Unité électrique de piste conductrice comprenant au moins un film de piste conductrice surmoulé avec une matière plastique, **caractérisé en ce que** le film de piste conductrice (4 ; 24) est disposé sur ou dans un élément de renfort surmoulé avec du plastique.

17. Unité de piste conductrice selon la revendication 16, **caractérisée en ce que** l'élément de renfort (6, 7 ; 26, 27 ; 56, 57, 57') est formé par un boîtier (8 ; 28).

18. Unité de piste conductrice selon la revendication 17, **caractérisée en ce que** des fenêtres (2, 3 ; 22, 23) pour la mise en contact avec des surfaces de contact conductrices du film de piste conductrice (4 ; 24) sont laissées libres dans le boîtier (8 ; 28) et dans l'enrobage de matière plastique (5 ; 25).

19. Unité de piste conductrice selon la revendication 17 ou 18, **caractérisée en ce que** le boîtier (4) présente un logement (15) en forme de capot dans lequel est disposé un composant (9) relié au film de piste conductrice (4).

20. Unité de piste conductrice selon l'une quelconque des revendications 17 à 19, **caractérisée en ce qu'**une partie de logement (40) séparée du boîtier (28), dans laquelle est disposé un composant (29), est formée à partir du matériau plastique de l'enrobage (25).

21. Unité de piste conductrice selon l'une quelconque des revendications 17 à 20, **caractérisée en ce que** le boîtier (8 ; 28) est conçu à l'extérieur avec par exemple des éléments d'espacement (17 ; 37) en forme de noppes, lesquels éléments sont encastrés dans le matériau plastique (5 ; 25) en se terminant au niveau de sa surface extérieure.

22. Unité de piste conductrice selon l'une quelconque des revendications 16 à 21, **caractérisée en ce qu'**également un composant par exemple électrique ou électromécanique est enrobé dans une matière plastique.

23. Unité d'enrobage pour le surmoulage avec une matière plastique selon un procédé selon l'une quelconque des revendications 12 à 15, **caractérisée par** un boîtier (8 ; 28) préfabriqué comprenant deux parties de boîtier (6, 7 ; 26, 27) s'adaptant, entre lesquelles est prévu, dans l'état assemblé, un espace de logement (14 ; 34) pour l'inclusion d'un film de piste conductrice (4 ; 24) entre les parties de boîtier.

24. Unité d'enrobage selon la revendication 23, **caractérisée en ce qu'**au moins une partie de boîtier (7) avec au moins une fenêtre (2', 3') est conçue pour la mise en contact avec le film de piste conductrice (4).

25. Unité d'enrobage selon la revendication 23 ou 24, **caractérisée en ce que** les deux parties de boîtier (6, 7 ; 26, 27) sont formées à l'extérieur avec des éléments d'espacement (17 ; 37) par exemple en forme de noppes.

26. Unité d'enrobage selon l'une quelconque des revendications 23 à 25, **caractérisée en ce que** au moins une partie de boîtier (26) est configurée avec une saillie (43), par exemple en forme de barrette, qui déborde par une fenêtre de l'autre partie de boîtier (27) lorsque les parties de boîtier (26, 27) sont assemblées.
